(19) Europäisches Patentamt
European Patent Office
Office européen des brevets

(11) Veröffentlichungsnummer: **0 388 875 A2**

(12) # EUROPÄISCHE PATENTANMELDUNG

(21) Anmeldenummer: **90105200.1**

(51) Int. Cl.[5]: **G03F 7/105**

(22) Anmeldetag: **20.03.90**

(30) Priorität: **21.03.89 DE 3909248**

(43) Veröffentlichungstag der Anmeldung: **26.09.90 Patentblatt 90/39**

(84) Benannte Vertragsstaaten: **BE CH DE FR GB IT LI NL**

(71) Anmelder: **BASF Aktiengesellschaft**
**Carl-Bosch-Strasse 38**
**D-6700 Ludwigshafen(DE)**

(72) Erfinder: **Bauer, Gerhard, Dr.**
**Uhlandstrasse 16**
**D-6940 Weinheim(DE)**
Erfinder: **Hoffmann, Gerhard, Dr.**
**Pappelstrasse 22**
**D-6701 Otterstadt(DE)**
Erfinder: **Hunger, Juergen, Dr.**
**Buergermeister-Gruenzweig-Strasse 13**
**D-6700 Ludwigshafen(DE)**
Erfinder: **Seitz, Friedrich, Dr.**
**Von-Wieser-Strasse 1**
**D-6701 Friedelsheim(DE)**

(54) **Lichtempfindliche Zubereitung und Verfahren zur Herstellung von Photoresisten und Druckplatten.**

(57) Die Erfindung betrifft lichtempfindliche Zubereitungen, im wesentlichen bestehend aus

(a) einem oder mehreren Farbbildnersystemen,

(b) gegebenenfalls einem oder mehreren filmbildenden polymeren Bindemitteln,

(c) gegebenenfalls einer oder mehreren Verbindungen mit mindestens einer ethylenisch ungesättigten Doppelbindung,

(d) gegebenenfalls einem durch Bestrahlung aktivierbaren Photoinitiator oder Photoinitiatorsystem und

(e) gegebenenfalls Zusatz- und/oder Hilfsstoffen, wobei die lichtempfindliche Zubereitung als Farbbildnersystem (a) ein Gemisch aus

(I) mindestens einem Hexaarylbisimidazolyl,

(II) mindestens einer halogenhaltigen Verbindung und

(III) mindestens einem zu einem Farbstoff oxidierbaren Farbbildner enthält.

Diese lichtempfindliche Zubereitung eignet sich zur Herstellung von Photoresisten.

EP 0 388 875 A2

## Lichtempfindliche Zubereitung und Verfahren zur Herstellung von Photoresisten und Druckplatten

Die Erfindung betrifft lichtempfindliche Zubereitungen sowie Verfahren zur Herstellung von photopolymerisierbaren Aufzeichnungsmaterialien, wie Photoresiste, Druckplatten und Informationsmedien.

Lichtempfindliche Zubereitungen enthalten bekanntlich als wesentlichen Bestandteil ein oder mehrere Farbbildnersysteme, die neben einem zu einem Farbstoff oxidierbaren Farbbildner (z.B. einem Leukofarbstoff) ein Photooxidationsmittel enthalten.

Lichtempfindliche Aufzeichnungsmaterialien für die Bilderzeugung und die oben genannten Anwendungszwecke sind an sich bekannt. Sie enthalten im allgemeinen neben einer photopolymerisierbaren, olefinisch ungesättigten organischen Verbindung, einem polymeren Bindemittel sowie einem Photopolymerisationsinitiator zur Erzeugung des sogenannten Print-Out-Image ein farbbildendes System, welches bei Bestrahlung mit aktinischem Licht in den bestrahlten Bereichen eine Farbänderung bewirkt. Diese Farbänderung ist für die visuelle Beurteilung und Kontrolle der Aufzeichnungsmaterialien nach der bildmäßigen Belichtung von großer Wichtigkeit. So ist es z.B. bei der Herstellung gedruckter Schaltungen oder Leiterplatten mittels Photoresistschichten notwendig, sich nach der bildmäßigen Belichtung und vor der Entfernung der unbelichteten Bereiche der Photoresistschichten zu vergewissern, ob das Negativ richtig aufgelegt war. Ferner ermöglicht die Farbänderung bei der bildmäßigen Belichtung von Schichten aus den photopolymerisierbaren Aufzeichnungsmaterialien eine Kontrolle des erhaltenen Bildes nach der Entwicklung der belichteten Schicht, so daß hierdurch beispielsweise etwaige Ablösungen der Bildteile der Schicht bei der Entwicklung leicht und zuverlässig festgestellt werden können. Um eine möglichst gute visuelle Beurteilung dieser belichteten Schichten vornehmen zu können, soll das farbbildende System bei der Belichtung einen möglichst starken Farbkontrast in den Aufzeichnungsmaterialien bewirken, wobei angestrebt wird, daß durch die Farbbildung möglichst dunkle Bilder bei Betrachtung im Gelblicht erhalten werden. Ferner müssen die farbbildenden Systeme lagerstabil sein, damit in den photopolymerisierbaren Aufzeichnungsmaterialien in der Zeit zwischen Herstellung und Anwendung keine unerwünschte Farbveränderung und Verschlechterung des Kontrasts nach dem Belichten auftritt. Eine häufige störende Folge einer unerwünschten Farbveränderung ist auch ein damit verbundener Rückgang der Lichtempfindlichkeit.

Die farbbildenden Systeme bestehen im allgemeinen aus einer farblosen oder schwach gefärbten Farbstoff-Vorstufe (Farbbildner) und einem Aktivator, der bei Bestrahlung mit aktinischem Licht die Farbstoff-Vorstufe in die farbige Verbindung überführt. Als Farbbildner kommen insbesondere Leukofarbstoffe oder die schwach gefärbten freien Basen oder Lactonformen von Farbstoffen in Betracht. Als Aktivatoren für die Farbbildner werden üblicherweise Photooxidationsmittel eingesetzt.

Die Verwendung von Hexaarylbisimidazol-Verbindungen als Photooxidationsmittel in photopolymerisierbaren Aufzeichnungsschichten ist bekannt (vgl. z.B. EP-A-24 629, US-A-3 479 185 und US-A-4 459 349). Wegen der geringen Eigenabsorption der Hexaarylbisimidazol-Verbindungen im aktinischen Bereich ist dazu in den meisten Fällen eine Sensibilisierung der Hexaarylbisimidazol-Verbindungen durch geeignete im aktinischen Bereich absorbierende Substanzen nötig. Als Sensibilisatoren besonders geeignete Substanzen sind beispielsweise p-Aminophenylketone (vgl. z.B. DE-A-1 924 317), bestimmte heterocyclische Stickstoffverbindungen (vgl. z.B. DE-A-37 17 038, DE-A-37 17 036, DE-A-37 17 034 und DE-A-37 17 033) oder auch Thioketone.

Auch die Kombination von Thioxanthon-Derivaten mit Hexaarylbisimidazol-Verbindungen war aus US-A-3 926 643 bekannt.

Es ist auch bereits bekannt, daß bestimmte organische Halogenverbindungen bei Bestrahlung mit aktinischem Licht Halogenradikale abspalten.

Außerdem waren auch Kombinationen aus einem Photopolymerisationsinitiatorsystem, wie Michlers Keton/Benzophenon, Michlers Keton/Benzophenon/Thioxanthon, Acridin- oder Phenazinverbindung und einer organischen Halogenverbindung als Photooxidationsmittel bekannt (vgl. z.B. DE-A-33 39 228, EP-A-131 824, DE-A-36 13 632 und EP-A-137 228).

Ein auf einen Schichtträger aufgebrachtes farbbildendes System ist in der DE-A-20 46 018 beschrieben. Dieses photographische, nicht photopolymerisierbare Aufzeichnungsmaterial dient zur Herstellung von gefärbten Bildern. Ihr Farbbildner-System besteht aus einem farblosen oder praktisch farblosen Farbbildner, der oxidativ in die gefärbte Form überführt werden kann, sowie einer heterocyclischen Verbindung mit einem durch einen Acyloxy- oder Alkoxy-Rest substituierten Ringstickstoffatom als Photooxidationsmittel. Als Farbbildner werden Leukofarbstoffe und deren Derivate beschrieben. Als Photooxidationsmittel sind speziell substituierte N-Alkoxy- bzw. N-Acyloxy-pyridinium-Salze genannt. Durch die Substituenten im Pyridinum-Rest wird das langwellige Absorptionsmaximum des Aktivators den jeweils verwendeten Strahlungsquellen angepaßt, d.h. das für den Leukofarbstoff als Photooxidationsmittel (Aktivator) eingesetzte

Pyridiniumsalz absorbiert bevorzugt aktinisches Licht mit einer Wellenlänge größer 400 nm. In der DE-A-34 33 026 wird als Farbbildner-System ebenfalls ein Alkoxypridiniumsalz mit einem speziellen Leukofarbstoff beschrieben. N-Alkoxypridiniumsalze werden auch als Photopolymerisationsinitiatoren allein (vgl. DE-A-19 50 746, DE-A-19 50 749, US-Re 27 925 oder US-A-3 574 622) oder in Kombination mit einem Ketocumarin als Sensibilisator für aktinisches Licht einer Wellenlänge >400 nm beansprucht (vgl. DE-A-31 35 399). Als Stand der Technik ergibt sich somit, daß N-Alkoxypyridiumsalze allein als Photooxidantien oder Photopolymerisationsinitiatoren wirken und durch Ketocumarine sensibilisiert werden können.

Es ist auch schon vorgeschlagen worden (vgl. z.B. DE-A-34 33 026) Azidverbindungen, wie 2-Azidobenzoxazol, Benzoylazid und 2-Azidobenzimidazol (US-A-3 282 693), Triazole und heterocyclische Ketimide (GB 1 030 887) sowie Hexaarylbisimidazole (vgl. DE-A-19 24 317 sowie EP-B-19 219) als Photooxidationsmittel zu verwenden. Von den bekannten photopolymerisierbaren Aufzeichnungsmaterialien, die insbesondere den zuletzt genannten Photooxidantientyp enthalten, weisen einige darüber hinaus zur Empfindlichkeitssteigerung und Verbesserung der Photoreaktion auch noch einen Sensibilisator, z.B. ein tertiäres Amin einer aromatischen Carbonylverbindung, z.B. Michler's Keton, auf.

Die in den bekannten Bilderzeugungsmaterialien eingesetzten farbbildenden Systeme zeigen bei der bildmäßigen Belichtung dieser Materialien mit aktinischem Licht häufig nur einen schwachen Farbumschlag und einen nicht zufriedenstellenden Kontrast zwischen belichteten und unbelichteten Bereichen.

Ein vielfach anzutreffendes Problem ist auch in der mangelnden Lagerstabilität der bisher für die Bilderzeugung verwendeten farbbildenden Systeme zu sehen. So ist in vielen Fällen bereits bei der Lagerung des unbelichteten Materials im Dunkeln eine Farbveränderung zu beobachten, die eine Verschlechterung des Kontrasts nach Belichtung und eine spürbare Verlängerung der erforderlichen Belichtungszeit (um bis zu 100 %) bewirkt. Die Verarbeitung von photopolymerisierbaren Aufzeichnungsmaterialien, die ein nicht lagerstabiles farbbildendes System enthalten, wird durch die beschriebene Farbvertiefung erheblich beeinträchtigt, weil z.B. die Kontrolle in der Leiterplattenfabrikation erschwert wird oder die erforderliche Belichtungszeit bei jedem Chargenwechsel neu ermittelt werden muß. In verschärfter Weise tritt das Problem der Farbvertiefung bei wäßrigalkalisch entwickelbaren Schichten auf, weil das saure Milieu die Farb vertiefung noch beschleunigt. Aus den genannten Gründen besteht daher nach wie vor ein Bedarf an verbesserten Bilderzeugungsmaterialien.

Aufgabe der vorliegenden Erfindung war es, ein Bilderzeugungsmaterial herzustellen, das die genannten Nachteile nicht aufweist, d.h. insbesondere ein Bilderzeugungsmaterial, das sich durch hohe Lagerstabilität über längere zeit auch bei erhöhter Temperatur und Luftfeuchtigkeit auszeichnet, sowie ein exzellentes Print-Out-Image, gute Belichtungs- und Prozeßeigenschaften sowie höhere Lichtempfindlichkeit besitzt.

Überraschenderweise wurde nun gefunden, daß sich ein besonders lagerstabiles Bilderzeugungsmaterial mit hervorragendem Print-Out-Image dadurch erhalten läßt, wenn man das erfindungsgemäße Farbbildnersystem einsetzt.

Gegenstand der vorliegenden Erfindung ist eine lichtempfindliche Zubereitungen, im wesentlichen bestehend aus

(a) einem oder mehreren Farbbildnersystemen,

(b) gegebenenfalls einem oder mehreren filmbildenden polymeren Bindemitteln,

(c) gegebenenfalls einer oder mehreren Verbindungen mit mindestens einer ethylenisch ungesättigten Doppelbindung,

(d) gegebenenfalls einem durch Bestrahlung mit aktinischem Licht aktivierbaren Photoinitiator oder Photoinitiatorsystem und

(e) gegebenenfalls Zusatz- und Hilfsstoffen, die dadurch gekennzeichnet ist, daß die lichtempfindliche Zubereitung als Farbbildnersystem (a) ein Gemisch aus

(I) mindestens einem Hexaarylbisimidazolyl der Formel (I)

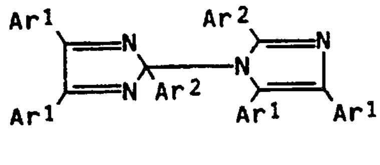

(I)

worin $Ar^1$ für einen substituierten oder unsubstituierten Phenylrest und $Ar_2$ für einen Phenylrest oder einen in 2- oder 2'-Position durch Halogen oder einen Alkylrest substituierten Phenylrest stehen, oder einer strukturisomeren Form davon und

(II) mindestens einer halogenhaltigen Verbindung der allgemeinen Formel (II),

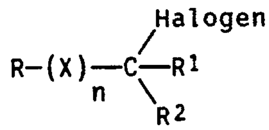

(II)

worin

R für einen unsubstituierten oder substituierten Alkyl-, Cycloalkyl-, Aryl-, Hetaryl- oder heterocyclischen Rest, oder den Rest

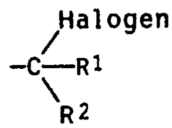

X für SO oder $SO_2$,

n = 1 oder 2,

$R^1$ und $R^2$ untereinander gleich oder verschieden sind und für ein Wasserstoffatom, Halogenatom, CN, unsubstituiertes oder durch Halogen, CN, OH, $NO_2$, COOH, $CONR^3{}_2$ (mit $R^3$ = H, Alkyl, Cycloalkyl oder heterocyclischer Rest), $COOR^4$ (mit $R^4$ = Alkyl, Cycloalkyl oder heterocyclicher Rest) oder Alkoxy substituierte Alkyl-, Cycloalkyl-, Aryl- oder Hetarylgruppen stehen,

und

(III) mindestens einem zu einem Farbstoff oxidierbaren Farbbildner enthält.

Im Farbbildnersystem (a) ist als zu einem Farbstoff oxidierbarer Farbbildner (III) vorzugsweise ein Leukofarbstoff enthalten.

Besonders bevorzugt sind solche lichtempfindlichen Zubereitungen, die im Farbbildnersystem (a) als halogenhaltige Verbindung (II) mindestens eine Verbindung der Formel

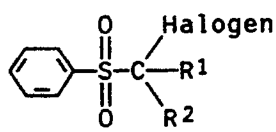

oder

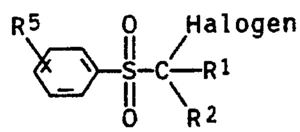

worin Halogen für Chlor oder Brom, $R^1$ und $R^2$ untereinander gleich oder verschieden sind und für Wasserstoff, Chlor oder Brom und $R^5$ für einen Alkylrest mit 1 bis 4 Kohlenstoffatomen stehen, enthalten.

Als filmbildendes polymeres Bindemittel (b) bevorzugt sind Copolymerisate mit einer Säurezahl zwischen 50 und 200.

Gegenstand der vorliegenden Erfindung sind ferner ein Verfahren zur Herstellung von Photoresisten, Flachdruck-, Hochdruck-, Flexodruck- oder Tiefdruckplatten, wobei erfindungsgemäße lichtempfindliche Zubereitungen eingesetzt werden.

Die erfindungsgemäßen lichtempfindlichen Zubereitungen lassen sich außerdem zur Herstellung von photopolymerisierbaren und/oder thermisch verarbeitbaren Kopiermassen verwenden.

Mit den erfindungsgemäßen lichtempfindlichen Zubereitungen lassen sich photoempfindliche Aufzeichnungsmaterialien mit sehr guten Belichtungseigenschaften und hervorragendem Print-Out-Image herstellen.

Zu den Aufbaukomponenten der erfindungsgemäßen lichtempfindlich Zubereitungen und den damit herstellbaren lichtempfindlichen Aufzeichnungselementen ist im einzelnen folgendes auszuführen.

Die erfindungsgemäßen lichtempfindlichen Zubereitungen enthalten als Farbbildnersystem (a) ein Gemisch aus

(I) mindestens einem Hexaarylbisimidazolyl der Formel (I)

(II) mindestens einer halogenhaltigen Verbindung der Formel (II) und

(III) mindestens einem zu einem Farbstoff oxidierbaren Farbbildner.

Als Hexarylbisimidazolyle der Formel (I)

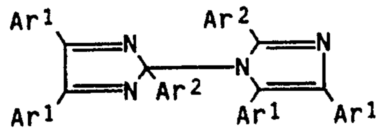

(I)

worin $Ar^1$ für einen substituierten oder unsubstituierten Phenylrest und $Ar^2$ für einen Phenylrest oder einen in 2- oder 2′-Position durch Halogen oder einen Alkylrest substituierten Phenylrest stehen, kommen beispielsweise solche 2,4,5-Triarylimidazol-Dimere in Betracht, bei denen zwei Imidazolreste durch eine kovalente Bindung verknüpft sind, wobei $Ar^1$ für einen Phenylrest oder vorzugsweise für einen in 4-Position durch einen mit $C_1$-$C_8$-Alkyl oder $C_1$-$C_6$-Alkoxy substituierten Phenylrest und $Ar^2$ für einen Phenyl oder vorzugsweise für einen in der 2- oder 2′-Position durch Halogen, wie F, Cl, Br oder Alkylrest substituierten Phenylrest steht. Aus den 2,4,5-Triarylimidazolyl-Dimeren entstehen durch Licht- und/oder Wärmeeinwirkung die eigentlichen Photooxidationsmittel, die Triarylimidazolyl-Radikale. Bevorzugte Hexaarylbisimidazolyle sind z.B. in US-A-3 784 557 und EP-A-24 629 beschrieben.

Besonders bevorzugt sind das 2,2′-Bis(o-chlorphenyl)-4,4′,5,5′-tetraphenylbisimidazolyl und das 2,2′-Bis(o-chlorphenyl)-4,4′,5,5′-tetra(p-methoxyphenyl)bisimidazolyl.

Diese Hexaarylbisimidazolyle sind an sich bekannt oder lassen sich leicht nach Methoden darstellen, wie sie beispielsweise in J. Org. Chem. 36, 2262 (1971) beschrieben sind.

Es eignen sich auch Gemische derartiger Hexarylbisimidazolyle sowie strukturisomere Formen der oben genannten Verbindungen der Formel (I).

Komponente (I) ist im erfindungsgemäß einzusetzenden Farbbildnersystem vorzugsweise in einer Menge von 0,1 bis 5, vorzugsweise 0,2 bis 3 Gew.-%, bezogen auf die gesamte lichtempfindliche Zubereitung, enthalten.

Als halogenhaltige Verbindungen der allgemeinen Formel (II)

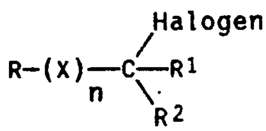

(II)

worin R, X, n, $R^1$ und $R^2$ die oben angegebene Bedeutung haben und Halogen für Chlor, Brom, Iod, insbesondere für Chlor oder Brom steht, kommen beispielsweise solche in Frage, in denen

R für einen unsubstituierten Alkylrest, z.B. einen geradkettigen Alkylrest mit 1 bis 10, vorzugsweise 1 bis 4 Kohlenstoffatomen, beispielsweise einen Methyl-, Ethyl-, n-Propyl-, n-Butylrest, einen verzweigten Alkylrest mit 3 bis 10, vorzugsweise 3 bis 7 Kohlenstoffatomen, beispielsweise einen Isopropyl oder Isobutylrest, einen Cycloalkylrest mit z.B. 5 bis 7, vorzugsweise 5 bis 6 Kohlenstoffatomen, beispielsweise den Cyclohexylrest, einen Arylrest, z.B. einen Phenylrest, einen Hetarylrest, einen heterocyclischen Rest, z.B. einen 4- bis 7-, vorzugsweise 5- oder 6-gliedrigen, N, O und/oder S enthaltenden Rest, z.B. Morpholinrest, einen entsprechend substituierten Alkyl-, Cycloalkyl-, Aryl-, Hetaryl- oder heterocyclischen Rest steht, wobei als Substituenten z.B. Halogen oder Alkyl, insbesondere mit 1 bis 4 C-Atomen in Frage kommen, oder den Rest

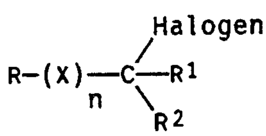

steht;

X für SO oder $SO_2$

n für 1 oder 2, wobei $X = SO_2$ und $n = 1$ bevorzugt sind;

$R^1$, $R^2$ untereinander gleich oder verschieden und für ein Wasserstoffatom, Halogen, wie z.B. Iod, Chlor oder Brom, CN, unsubstituierte Alkylreste, z.B. der unter R genannten Art, durch Halogen, wie z.B. Chlor oder Brom, CH, OH, $HO_2$, COOH, $CONR^3{}_2$ mit $R^3$ = H, Alkyl-, Cycloalkyl- oder heterocyclischer Rest, z.B. der unter R genannten Art, $COOR^4$ mit $R^4$ = Alkyl-, Cycloalkyl- oder heterocyclischer Rest der unter R genannten Art, oder Alkoxy, mit z.B. 1 bis 4 Kohlenstoffatomen, wie z.B. Methoxy oder Ethoxy substituierte Alkyl-, Cycloalkyl-, Aryl- oder Hetarylgruppen

stehen können.

Beispiele für bevorzugte Verbindungen der allgemeinen Formel (II) sind:

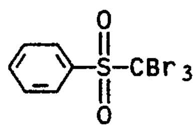 ; 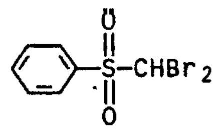 ;

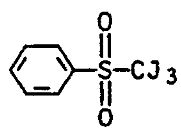 ; 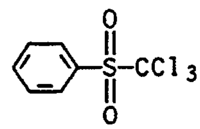 ;

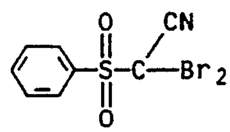 ; 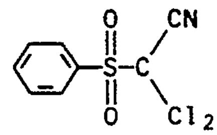 ;

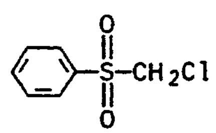 ; 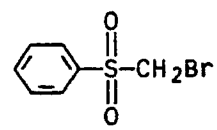 ;

Komponente (II) ist im erfindungsgemäß einzusetzenden Farbbildnersystem (a) vorzugsweise in einer Menge von 0,1 bis 5, vorzugsweise 0,2 bis 3 Gew.-%, bezogen auf die gesamte lichtempfindliche Zubereitung, enthalten.

Als zu einem Farbstoff oxidierbaren Farbbildner (III) eignen sich insbesondere Leukofarbstoffe.

Geeignet sind insbesondere die Diarylmethan- und Triarylmethan-Farbstoffe in ihrer Leukoform bzw. Farbstoffe mit einer Triarylmethan-Grundstruktur, bei denen zwei der Arylreste über ein N-, S- oder O-Atom miteinander verknüpft sind. Hierzu gehören unter anderem die Leukoform der Aminoacridin-Farbstoffe, der Aminoxanthen-Farbstoffe und der Aminothioxanthen-Farbstoffe. Ferner können als Farbbildner auch Leukomethine eingesetzt werden. Leukofarbstoffe, die als Farbbildner für die erfindungsgemäßen photopolymerisierbaren Aufzeichnungsmaterialien geeignet sind, sind beispielsweise in der US-A-3 552 973 beschrieben. Von besonderem Interesse sind dabei die Leukotriarylmethanfarbstoffe, wie z.B. Leukokristallviolett, Leukomalachitgrün, Leukobasischblau, Leukopararosanilin, Leukopatentblau A oder V.

Komponente (III) ist im erfindungsgemäß einzusetzenden Farbbildnersystem (a) vorzugsweise in einer Menge von 0,1 bis 4, vorzugsweise 0,5 bis 2 Gew.-%, bezogen auf die gesamte lichtempfindliche Zubereitung, enthalten.

Das erfindungsgemäße Farbbildnersystem (a) kann zur Herstellung von lichtempfindlichen Aufzeichnungselementen und Photoresists sehr vorteilhaft eingesetzt werden.

Derartige lichtempfindliche Aufzeichnungselemente, insbesondere Trockenfilmresiste, bestehen im allgemeinen aus einer auf einem dimensionsstabilen, temporären Träger aufgebrachten, festen, wäßrig-, insbesondere wäßrig-alkalisch-, entwickelbaren, photopolymerisierbaren Resistschicht sowie gegebenenfalls einer abziehbaren Deckfolie auf dieser Resistschicht. Zur Herstellung von Resistmustern auf einem Substrat wird auf das Substrat eine photopolymerisierbare, in wäßrigen - insbesondere wäßrig-alkalischen - Entwicklerlösungsmitteln lösliche oder dispergierbare Resistschicht aufgebracht, die Resistschicht bildmäßig mit aktinischem Licht belichtet und wurden anschließend die nicht belichteten Bereiche der Resistschicht mit dem Entwickerlösungsmittel ausgewaschen.

Die lichtempfindliche Zubereitung kann aber auch für Photoresiste eingesetzt werden, die nicht in wäßrig-alkalischen Medien, sondern nur in organischen Medien (z.B. chlorierten Kohlenwasserstoffen) verarbeitet werden können.

Trockenfilmresists finden breite Anwendung zur Herstellung von Resistmustern in der Ätz- oder Galvano-Technik, bei der Herstellung von Leiterplatten sowie Dünnschicht- und Mehrschichtschaltungen. Dabei gewinnen die wäßrig entwickelbaren Photoresists wegen ihrer umweltfreundlicheren Verarbeitbarkeit im Vergleich zu den mit organischen Lösungsmitteln entwickelbaren Resists immer stärker an Bedeutung. Die photopolymerisierbare Resistschicht enthält dabei im allgemeinen eine Mischung von mindestens einem in wäßrigen Medien, insbesondere wäßrig-alkalischen Medien, löslichen bzw. dispergierbaren filmbildenden polymeren Bindemittel (b), mindestens eine ethylenisch ungesättigte, photopolymerisierbare niedermolekulare Verbindung (c), mindestens einen Photoinitiator (d) sowie gegebenenfalls weitere Zusatz- und/oder Hilfsstoffen (e).

Als filmbildende polymere Bindemittel (b) für die wäßrig entwickelbaren Resistschichten sind insbesondere Carboxyl-Gruppen oder Carbonsäureanhydrid-Gruppen enthaltende Polymere geeignet, wie z.B. Alkyl-(meth)acrylat/(Meth)acrylsäure-Copolymerisate, Styrol/Maleinsäureanhydrid- Copolymerisate, Styrol/Maleinsäurehalbester-Copolymerisate oder auch Styrol/Alkyl-(meth)acrylat/(Meth)acrylsäure-Copolymerisate (vgl. u.a. DE-B-20 64 080, DE-A-22 05 146 und EP-A-49 504), die gegebenenfalls weitere Comonomere einpolymerisiert enthalten können (vgl. u.a. DE-B-20 27 467, SU-PS 190 211, DE-A-22 05 146 oder DE-A-27 36 058).

Als photopolymerisierbare niedermolekulare Verbindungen für diese Resistschichten kommen insbesondere verschiedenartige Acrylat- und Methacrylat-Verbindungen, insbesondere Monomere, in Frage, wobei die photopolymerisierbaren Resistschichten üblicherweise 40 bis 90 Gew.-% der polymeren Bindemittel und 10 bis 60 Gew.-% der photopolymerisierbaren niedermolekularen Verbindungen enthalten können.

Auch zur Herstellung von photopolymeren Druck- oder Reliefformen können derartige photopolymerisierbare Gemische eingesetzt werden, z.B. solche, die neben photopolymerisierbaren Monomeren, mindestens einem Photoinititator sowie gegebenenfalls weiteren Zusatz- und/oder Hilfsstoffen als polymere Bindemittel Vinylpyrrolidon-Polymerisate, wie z.B. Polyvinylpyrrolidon oder Vinylpyrrolidon/Vinylacetat-Copolymerisat, enthalten (vgl. z.B. DE-A-1 797 373). Diese photopolymerisierbaren Gemische sind mit wäßrigen Lösungsmitteln, insbesondere reinem Wasser, entwickelbar.

Bei den Verbindungen (c) mit mindestens einer ethylenisch ungesättigten Doppelbindung handelt es sich in aller Regel um niedermolekulare Verbindungen, insbesondere Monomere. Die Verbindungen (c), die üblicherweise einen Siedepunkt bei Atmosphärendruck von über 100 °C aufweisen, haben im allgemeinen ein Molekulargewicht unter 10.000. Die photopolymerisierbaren Monomeren, die allein oder in Mischung miteinander eingesetzt werden können, können dabei sowohl mono- als auch polyfunktionell sein, d.h. sie können eine oder mehrere photopolymerisierbare ethylenische Doppelbindungen besitzen. Vorteilhafterweise sind in den erfindungsgemäßen photopolymerisierbaren Schicht Monomere mit zwei oder mehr photopolymerisierbaren ethylenischen Doppelbindungen enthalten. Diese bi- oder mehrfunktionellen Monomeren können dabei allein, in Mischung miteinander oder in Mischung mit monofunktionellen Monomeren, d.h. Monomeren mit nur einer photopolymerisierbaren ethylenischen Doppelbindung, eingesetzt werden. Vorzugsweise kommen solche Monomeren zur Anwendung, die mindestens eine endständige Vinyl- oder Vinyliden-Doppelbindung aufweisen, und insbesondere solche, bei denen die photopolymerisierbare Doppelbindung bzw. die photopolymerisierbaren Doppelbindungen durch Konjugation oder durch Nachbarschaftsstellung zu O-, N- oder S-Atomen aktiviert sind.

Als Vertreter für die photopolymerisierbaren Monomeren seien neben den Allylverbindungen, wie z.B. Allylacrylat und Diallylphthalat und Vinyl verbindungen, wie z.B. N-Vinyllactamen und insbesondere N-Vinylpyrrolidon oder N-Vinylcaprolactam, vornehmlich die Acryloyl- und/oder Methacryloyl-Gruppen enthaltenden Monomeren genannt. Hierzu gehören insbesondere die Ester der Acrylsäure und Methacrylsäure, wie z.B. die Di- und Tri(meth)acrylate etwa von Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,1,1-Trimethylolpropan, 2,2-Dimethylpropandiol, Glycerin oder Pentaerythrit; Pentarythritetra-(meth)acrylat, Glukosetetra(meth)acrylat; Urethanacrylate und -methacrylate mit 2 oder mehr Acryloyl-bzw. Methacryloyl-Gruppen, wie sie beispielsweise durch Umsetzung von aliphatischen Diolen oder Polyolen der vorstehend genannten Art mit organischen Diisocyanaten, z.B. Hexamethylendiisocyanat, im Äquivalentverhältnis OH:NCO von etwa 1:2 und anschließende Umsetzung der freien Isocyanatgruppen mit Monohydroxy(meth)acrylaten, insbesondere Hydroxyalkyl-(meth)acrylaten hergestellt werden können; Methacrylsäureester mit zwei oder mehr Acryloyl- und/oder Methacryloyl-Gruppen, wie sie durch Umsetzung von Acrylsäure und/oder Methacrylsäure mit Di- oder Polyglycidylverbindungen, insbesondere Di- oder Polyglycidylethern, erhalten werden können, wie z.B. das Umsetzungsprodukt aus 2 Mol Acrylsäure und/oder Methacrylsäure mit einem Mol Bisphenol A-bisglycidylether. Als Beispiel für monofunktionelle Monomere seien die Monoacrylate und Monomethacrylate von Monoalkanolen, insbesondere mit 1 bis 20 C-Atomen, oder der oben genannten Diole und Polyole erwähnt. Zu den besonders bevorzugten Monomeren gehören unter anderem Trimethylolpropantriacrylat, Trimethylolpropantrimethacrylat, Pentaerythrittri- und -tetraacrylat sowie Pentaerythrittri- und -tetramethacrylat.

Photopolymere Zubereitungen können auch Oligomere, insbesondere oligomere carboxylgruppenhaltige Polyesteracrylate und/oder -methacrylate enthalten. Solche carboxylgruppenhaltigen Polyester-(meth)-acrylate können auf verschiedene Art und Weise erhalten werden. Beispielsweise gelangt man zu geeigneten Oligomeren, wenn man (Meth)acryloyl-Gruppen enthaltende Diole unter Kettenverlängerung mit Polycarbonsäuren, insbesonder Tri- oder Tetracarbonsäuren und bevorzugt deren cyclischen Anhydriden umsetzt. Bei den (Meth)acryloyl-Gruppen enthaltenden Diolen kann es sich beispielsweise um Reaktionsprodukte von Dicarbonsäuren mit Glycidyl(meth)acrylat handeln. In gleicher Weise kommen jedoch auch Reaktionsprodukte von Epoxidverbindungen mit (Meth)acrylsäure in Betracht, wie beispielsweise das Umsetzungsprodukt von Glycidol mit (Meth)acrylsäure. Als besonders vorteilhaft für die ungesättigte Diol-Komponente haben sich die Reaktionsprodukte von Acryl- und/oder Methacrylsäure mit Diepoxiden, insbesondere aromatischen Diepoxiden, erwiesen. Hier sei insbesondere das Umsetzungsprodukt aus Bisphenol A-Glycidylether mit Acryl- und/oder Methacrylsäure im molaren Verhältnis von 1:2 genannt. Die (Meth)-acryloyl-Gruppen enthaltenden Diole können zur Herstellung der carboxylgruppenhaltigen oligomeren Polyester allein oder auch in Mischung mit anderen, gesättigten Diolen, wie z.B. 1,4-Butandiol, Polyethylenglykolen, Polypropylenglykolen, Polybutylenglykolen oder ähnlichen eingesetzt werden. Das Verhältnis der die (Meth)acryloyl-Gruppen enthaltenden Diole zu den gesättigten Diolen richtet sich dabei nach dem gewünschten Gehalt an Acryloyl- und/oder Methacryloyl-Gruppen in dem oligomeren. Im allgemeinen beträgt der Anteil der gesättigten Diole 0 bis 90 Gew.-%, vorzugsweise 50 bis 80 Gew.-% bezogen auf die gesamte für die Herstellung der oligomeren Polyester eingesetzte Diol-Komponente. Als Säurekomponente für die Herstellung der Polyester-Oligomeren, die gleichzeitig der Kettenverlängerung der Diole wie auch der Einführung von freien Carboxylgruppen in das Polyester-Oligomere dient, haben sich neben den Tri- und Tetracarbonsäuren insbesondere die cyclischen Dianhydride von Tetracarbonsäuren als besonders vorteilhaft erwiesen. Beispielhaft hierfür sei das Pyromellithsäureanhydrid genannt. Zur Herstellung der oligomeren, freie Carboxylgruppen und (Meth)acryloyl-Gruppen enthaltenden Polyester werden die die (Meth)acrylol-Gruppen enthaltenden Diole, gegebenenfalls in Mischung mit gesättigten Diolen, in an sich bekannter Weise mit den Carbonsäuren bzw. deren Anhydriden im Äquivalentverhältnis Diol-Komponente:Carbonsäurekomponente von etwa 1:0,6 umgesetzt.

Oligomere, freie Carboxylgruppen und Acryloyl- und/oder Methacryloyl-Gruppen enthaltende Polyester, die sich für die photopolymerisierbaren Resistschichten eignen, können beispielsweise auch erhalten werden, indem man die Hydroxylgruppen von mehrfunktionellen gesättigten Polyesterpolyolen partiell mit Acrylsäure und/oder Methacrylsäure verestert und anschließend die restlichen Hydroxyl-Gruppen ganz oder teilweise mit Dicarbonsäuren bzw. Dicarbonsäurederivaten, insbesondere cyclischen Dicarbonsäureanhydriden umsetzt. Als Ausgangskomponente kommen hierzu beispielsweise die bekannten Polyesterpolyole in Betracht, wie sie etwa durch Umsetzung von aliphatischen und/oder aromatischen Dicarbonsäuren bzw. deren Derivaten mit mindestens trifunktionellen Polyolen oder Mischungen aus mindestens trifunktionellen Polyolen und Diolen bzw. durch Umsetzung von Dicarbonsäuren mit Di- oder Polyepoxiden erhalten werden können.

Ferner ist in der erfindungsgemäßen photopolymerisierbaren Resistschicht mindestens ein Photopolymerisationsinitiator oder Photoinitiatorsystem (d) enthalten. Hierfür kommen insbesondere die für die Herstellung von photopolymerisierbaren Resistschichten bekannten und üblichen Photoinitiatoren bzw. Photoinitiatorsysteme in Betracht. Dazu gehören Benzoin und Benzoin derivate, wie Benzoinether; substituierte Benzoine und substituierte Benzoinderivate, z.B. substituierte Benzoinether; Benzile, insbesondere Benzilketale, wie z.B. Benzildimethylketal, Benzilmethylethylketal oder Benzilmethylbenzylketal; und die als Photoinitiatoren bekannten und wirksamen Benzoyldiarylphosphinoxide. Besonders vorteilhaft für die Photopolymerisationsinitiatorsysteme sind Verbindungen vom Typ des Benzophenons und seiner Derivate, wie Benzophenon, 4,4′-Dimethylaminobenzophenon, Derivate von Michler's Keton, 4,4′-Dichlorbenzophenon etc., sowie deren Gemische, insbesondere Mischungen aus Benzophenon und Michler's Keton; Hexaarylbisimidazole, wie z.B. 2,2′-o-chlorphenyl-4,4′,5,5′-p-methoxyphenyl-bisimidazol; mehrkernige unsubstituierte oder substituierte Chinone, wie Anthrachinon, Benzanthrachinon, 2-Ethylanthrachinon oder tert.-Butylanthrachinon; sowie die als Photoinitiatoren wirksamen Acridin- oder Phenacin-Derivate. Typische Beispiele für Photoinitiatorsysteme sind Kombinationen aus Benzophenon oder Benzophenon-Derivaten mit tertiären Aminen, wie Triethanolamin oder Michler's Keton, oder die bekannten Hexaarylbisimidazol/Sensibilisator-Gemische. Als Verbindungen mit Thioxanthon-Struktur kommen im allgemeinen Thioxanthon und dessen Derivate, d.h. Thioxanthone mit einem oder zwei Substituenten in Betracht. Bevorzugte Verbindungen mit Thioxanthon-Struktur sind solche Thioxanthone, die einen oder mehrere Alkylsubstituenten tragen, wobei die verschiedenen möglichen Isomeren einzeln oder im Gemisch eingesetzt werden können. Beispiele für besonders geeignete Thioxanthonderivate sind Methylthioxanthon, Isopropylthioxanthon und Diethylthioxanthon.

Als Beispiele für Sensibilisatoren in den Photoinitiatorsystemen seien u.a. Dimethylaminobenzoesäureethylester bzw. allgemein Amine oder aminogruppenhaltige Verbindungen wie Dialkylaminobenzaldehyd-Verbindungen, Ester der p-Dialkylaminobenzoesäure und Hydroxyalkylamine, wie Mono-, Di- und Trialkanolamine. Besonders bevorzugte Amine sind Triethanolamin, Ethanolamin, Diethanolamin, N-Mthyldiethanolamin und ähnliche Alkoxyalkylamine.

In photoempfindlichen Zubereitungen können auch noch weitere Zusatz-und/oder Hilfsstoffe (e) enthalten sein. Hierzu gehören u.a. thermische Polymerisationsinhibitoren, wie z.B. Hydrochinon, Hydrochinon-Derivate, 2,6-Di-tert.-butyl-p-kresol, Nitrophenole, N-Nitrosoamine, wie N-Nitrodiphenylamin oder die Salze des N-Nitrosocyclohexylhydroxylamins. Außerdem werden oftmals Silikate oder sonstige anorganische Füllstoffe zugesetzt. Als weitere Zusatz und/oder Hilfsstoffe kommen z.B. Farbstoffe, Pigmente, sensitometrische Regler, Weichmacher, Verlaufshilfsmittel, Mattierungs-oder Gleitmittel und dergleichen in Betracht. Beispiele für gegebenenfalls zuzusetzende Farbstoffe und/oder Pigmente, sind u.a. Brilliant Green Dye (C.I. 42 040), Viktoria-Reinblau FGA, Viktoria-Reinblau 80 (C.I. 42 595), Viktoria-Blau B (C.I. 44 045), Rhodamin G 6 (C.I. 45 160), Triphenylmethanfarbstoffe, Naphthalimidfarbstoffe und 3′-Phenyl-7-dimethylamino-2,2′-spirodi-(2H-1-benzopyran). Als Weichmacher können die an sich bekannten und üblichen niedermolekularen oder hochmolekularen Ester, wie Phthalate oder Adipate, Toluolsulfonamid oder Tricresylphosphat, dienen. Die Zusatz- und/oder Hilfsstoffe sind in den photopolymerisierbaren Zubereitungen in den für diese Stoffe üblichen und bekannten wirksamen Menge vorhanden. Ihre Menge sollte jedoch im allgemeinen 30 Gew.-%, vorzugsweise Gew.-%, bezogen auf die lichtempfindliche Zubereitungen, nicht überschreiten.

Als Träger für die photopolymerisierbaren Aufzeichnungsschichten kommen die für lichtempfindliche Aufzeichnungselemente der in Rede stehenden Art üblichen und an sich bekannten dimensionsstabilen, starren oder vorzugsweise flexiblen Schichtträger in Betracht, wobei die Art des Schichtträgers vom Verwendungszweck der lichtempfindlichen Aufzeichnungselemente mitbestimmt wird. So komme für die Herstellung von Druckplatten als dimensionsstabile Träger insbesondere Kunststoff-Filme oder -Folien, z.B. aus Polyestern, sowie metallische Schichtträger, beispielsweise aus Stahl oder Aluminium, in Betracht. Für trocken laminierbare Photoresistfilme und Schichtübertragungsmaterialien finden als Trägermaterialien vorzugsweise Kunststoff-Filme oder -Folien, insbesondere Polyester-Folien, Verwendung, die eine mäßige Haftung zu der photopolymerisierbaren Aufzeichnungsschicht haben und nach dem Auflaminieren bzw. Aufkaschieren der photopolymerisierbaren Aufzeichnungsschicht auf ein Substrat von dieser - vor oder nach der Belichtung mit aktinischem Licht - abgezogen werden können. Für die Herstellung von Resistmustern kann die photopolymerisierbare Aufzeichnungsschicht auch direkt auf das zu schützende sowie gegebenenfalls dauerhaft zu modifizierende Substrat aufgebracht werden, welches dann als Träger für die photopolymerisierbare Aufzeichnungsschicht fungiert. Als Substrate für Photoresistschichten kommen beispielsweise Kupferbleche, kupferkaschierte Resistmaterialien, Keramiksubstrate, die mit metallischen oder metalloxidischen Schichten beschichtet sind, Halbleiterelemente, Silicium-Wafer und dergleichen in Betracht. Die Trägermaterialien für die photopolymerisierbaren Aufzeichnungsschichten können gegebenenfalls in an sich bekannter Weise, z.B. mechanisch, chemisch, elektrochemisch und/oder durch Versehen mit einer Haftgrundierung, vorbehandelt sein. Gleichermaßen können zwischen photopolymerisierbarer Aufzeichnungsschicht und Träger auch noch eine oder mehrere Zwischenschichten angeordnet sein. Bei lichtempfindlichen Aufzeichnungselementen für die Herstellung von Druckformen, insbesondere Hochdruck- oder Tiefdruckformen, können diese Zwischenschichten als Haftschicht und/oder Lichthofschutzschicht ausgebildet sein. Bei Photoresistfilmen und Schichtübertragungsmaterialien kann eine solche Zwischenschicht zwischen photopolymerisierbarer Aufzeichnungsschicht und dem abziehbaren, temporären Schichtträger das Abziehen des Schichtträgers nach dem Auflaminieren bzw. Aufkaschieren der photopolymerisierbaren Aufzeichnungsschicht auf das Substrat erleichtern und/oder als Sauerstoffsperrschicht nach dem Abziehen des Schichtträgers dienen.

Ebenso kann auf der dem Träger abgewandten Oberfläche der photopolymerisierbaren Aufzeichnungsschicht auch noch eine Deckschicht oder Deckfolie angeordnet sein, die vorzugsweise in dem gleichen Entwickler-Lösungsmittel löslich ist wie die photopolymerisierbare Aufzeichnungsschicht, oder von dieser abziehbar ist. Diese Deckschicht bzw. Deckfolie dient vor allem dem Schutz der photopolymerisierbaren Aufzeichnungsschicht bei der Lagerung und Handhabung der lichtempfindlichen Aufzeichnungselemente und gegebenenfalls auch als Sauerstoffsperre für die photopolymerisierbare Aufzeichnungsschicht. Als besonders geeignet haben sich z.B. Deckschichten aus Polyvinylalkoholen oder Polyvinylalkohol-Derivaten bzw. - insbesondere bei Photoresistfilmen - Deckfolien aus Polyolefinen, wie z.B. Polyethyen oder Polypropylen, erwiesen.

Die Herstellung der erfindungsgemäßen lichtempfindlichen Aufzeichnungselemente kann in an sich bekannter und üblicher Weise durch Herstellung einer homogenen Mischung der die photopolymerisierbare Aufzeichnungsschicht bildenden Komponenten und schichtförmiges Aufbringen dieser Mischung auf den - gegebenenfalls mit einer Zwischenschicht versehenen -Träger erfolgen. Beispielsweise kann man die Komponenten der photopolymerisierbaren Aufzeichnungsschicht rein mechanisch in einer geeigneten Mischvorrichtung, z.B. einem Mischer oder Extruder, homogen vermischen und diese Mischung, beispielsweise durch Extrudieren, Kalandrieren oder Pressen, zu einer Schicht der gewünschten Dicke formen, die dann auf den Träger auflaminiert bzw. aufkaschiert wird. Vorteilhafterweise werden die lichtempfindlichen Aufzeichungselemente jedoch hergestellt, indem man die Komponenten der photopolymerisierbaren Aufzeichnungsschicht in einem geeigneten Lösungsmittel oder Lösungsmittelgemisch löst und diese Lösung durch Gießen, Tauchen, Sprühen oder andere bekannte Auftragstechniken in der gewünschten Schichtstärke auf den Träger aufbringt. Anschließend wird das Lösungsmittel in üblicher Weise entfernt und die photopolymerisierbare Aufzeichnungsschicht getrocknet. Geeignete Lösungsmittel für das Mischen der Komponenten und Aufbringen der photopolymerisierbaren Aufzeichnungsschicht auf den Träger sind u.a. niedere Alkohole, Ketone oder Ester, wie z.B. Methanol, Aceton, Methylethylketon, Ethylacetat und ähnliche, sowie Mischungen hiervon. Anschließend kann auf die photopolymerisierbare Aufzeichnungsschicht gewünschtenfalls noch die Deckschicht oder Deckfolie aufgebracht werden.

Die erfindungsgemäßen lichtempfindlichen Aufzeichnungselemente eignen sich in vorteilhafter Weise für die Herstellung von Druckformen oder Resistmustern nach den hierfür an sich bekannten und üblichen Verfahren. Hierzu wird die photopolymerisierbare Aufzeichnungsschicht - bei Photoresistfilmen und Schichtübertragungsmaterialien nach der Schichtübertragung auf das zu schützende Substrat - bildmäßig mit aktinischem Licht belichtet, wobei sich hierfür die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impulslampen, aber auch UV-Laser, Argonlaser und ähnliche, eignen. Die von den Lichtquellen emittierte Wellenlänge soll im allgemeinen zwischen 230 und 450 nm, bevorzugt zwischen 300 und 420 nm, liegen und insbesondere auf die Eigenabsorption des in der photopolymerisierbaren Aufzeichnungsschicht erhaltenen Photoinitiators abgestimmt sein.

Durch die bildmäßige Belichtung mit dem aktinischen Licht wird in den belichteten Bereichen der Aufzeichnungsschicht eine Photopolymerisation ausgelöst, die zu einer Vernetzung in den belichteten Schichtbereichen und damit zu einer Löslichkeitsdifferenzierung zwischen den belichteten und unbelichteten Schichtbereichen führt. Nach der bildmäßigen Belichtung wird die Druckform bzw. das Resistmuster durch Auswaschen der unbelichteten, unvernetzten Bereiche der Aufzeichnungsschicht mit einem geeigneten Entwicklerlösungsmittel, insbesondere einer wäßrig-alkalischen Entwicklerlösung entwickelt. Das Entwikkeln kann durch Waschen, Sprühen, Reiben, Bürsten etc. erfolgen.

Die erfindungsgemäßen lichtempfindlichen Aufzeichnungselemente zeichnen sich durch gute Belichtungseigenschaften, wodurch es möglich ist, auch sehr feine Bildelemente vorlagengetreu und sicher zu reproduzieren. Die erfindungsgemäßen lichtempfindlichen Aufzeichnungsmaterialien eignen sich grundsätzlich für alle Anwendungsgebiete der Reprographie und optischen Informationsfixierung.

Die Erfindung wird durch die nachfolgenden Beispiele näher erläutert. Die in den Beispielen genannten Teile und Prozente beziehen sich, sofern nicht anders angegeben, auf das Gewicht.

Beispiel 1

Unter Rühren wurde eine 48 %ige homogene Lösung in Aceton/Methanol 1:1 mit folgenden Bestandteilen hergestellt:

61,0 % eines Copolymers aus 57 Gew.-% Methylmethacrylat, 23 Gew.-% Methacrylsäure, 20 Gew.-% Ethylacrylat mit einem mittleren Molekulargewicht von etwa 85000
17,0 % Trimethylolpropantriacrylat
12,0 % Tetraethylenglykoldimethacrylat
2,7 % Dibutylphthalat
1,23 % Bis(dimethylaminophenyl)[ethyl(phenyl)-aminophenyl]methan
2,0 % Malachitgrün
2,0 % 2,2′-Bis(o-chlorphenyl)-4,4′,5,5′-tetra-(p-methoxyphenyl)-bisimidazolyl
2,0 % Tribrommethylphenylsulfon
0,5 % Isopropylthioxanthon
1,5 % Ethyl-(p-dimethylamino)benzoat

Die Lösung wurde durch einen Druckfilter filtriert und dann in solcher Schichtstärke auf eine 23 µm dicke Polyethylenterephthalat-Folie gegossen, daß nach Ablüften der Lösungsmittel und Trocknen (3 Minuten bei 80 °C) eine Trockenfilmdicke von 38 µm resultierte. Die photopolymerisierbare Resistschicht wurde bis zur Weiterverarbeitung des so erhaltenen Trockenfilmresistes mit einer 23 µm dicken Polyethylen-Folie abgedeckt. Zur Herstellung von Leiterbahnen wurde diese photopolymerisierbare Resistschicht nach Abziehen der Polyethylendeckfolie bei 80 °C bis 120 °C auf ein kupferkaschiertes Leiterplattensubstrat auflaminiert und in einem handelsüblichen PC-Printer bildmäßig mit aktinischem Licht durch

einen Graukeil, dessen aufeinanderfolgende Stufen sich in ihrer optischen Dichte jeweils um $\sqrt[4]{2}$ unterschieden, sowie durch ein Leiterbahnenmotiv belichtet. Der Photoresist besitzt ein hervorragendes Print-Out-Image (Wiedergabe der Belichtungsvorlage).

Das hervorragende Print-out-Image läßt sich sehr gut durch den Kontrast zwischen unbelichtetem und belichtetem Resist messen. Der Photoresist zeigt eine Zunahme der Extinktion bei Belichtung von 0,26 (600 nm) auf 1,36 (600 nm).

Nach Entwickeln in einer 1 %igen wäßrigen Sodalösung bei 30° C zeigte der Resist einen exzellenten Kontrast zum Kupfer. Der Kontrast zum Basismaterial ist nach allen allgemein üblichen Verarbeitungsschritten (Ätzen, Tenting, Galvanik) sehr gut.

Beispiel 2

Unter Rühren wurde eine 48 %ige homogene Lösung in Aceton/Methanol 1:1 mit folgenden Bestandteilen hergestellt:
61,0 % eines Copolymers aus 57 Gew.-% Methylmethacrylat, 23 Gew.-% Methacrylsäure, 20 Gew.-% Ethylacrylat mit einem mittleren Molekulargewicht von etwa 85000
18,0 % Trimethylolpropantriacrylat
13,0 %Tetraethylenglykoldimethacrylat
2,7 % Dibutylphthalat
1,23 % Bis(dimethylaminophenyl)[ethyl(phenyl)-aminophenyl]methan
0,07 % Malachitgrün
1,0 % 2,2′-Bis(o-chlorphenyl)-4,4′,5,5′-tetra-(p-methoxyphenyl)-bisimidazolyl
1,0 % Tribrommethylphenylsulfon
0,5 % Isopropylthioxanthon
1,5 % Ethyl-(p-dimethylamino)benzoat

Der Photoresist zeigte nach analoger Verarbeitung wie im Beispiel 1 einen sehr guten Kontrast. Die Extinktion nahm durch die Belichtung von 0,26 (600 nm) auf 0,80 (600 nm) zu.

Vergleichsbeispiel 1

Unter Rühren wurde eine 48 %ige homogene Lösung in Aceton/Methanol 1:1 mit folgenden Bestandteilen hergestellt:
61,0 % eines Copolymers aus 57 Gew.-% Methylmethacrylat, 23 Gew.-% Methacrylsäure, 20 Gew.-% Ethylacrylat mit einem mittleren Molekulargewicht von etwa 85000
18,5 % Trimethylolpropantriacrylat
13,5 % Tetraethylenglykoldimethacrylat
2,7 % Dibutylphthalat
1,23 % Bis(dimethylaminophenyl)[ethyl(phenyl)-aminophenyl]methan
0,07 % Malachitgrün
1,0 % 2,2′-Bis(o-chlorphenyl)-4,4′,5,5′-tetra-(p-methoxyphenyl)-bisimidazolyl
0,5 % Isopropylthioxanthon
1,5 % Ethyl-(p-dimethylamino)benzoat

Nach analoger Verarbeitung des Photoresistes wie in Beispiel 1 beschrieben zeigte es sich, daß der Kontrast nach Belichtung deutlich schlechter war als in den Beispielen 1 und 2. Man erhielt nur eine Zunahme der Extinktion bei Belichtung von 0,27 (600 nm) auf 0,43 (600 nm).

Der Kontrast des belichteten Resistes zum Kupfer nach Entwicklung sowie zum Basismaterial nach Ätzen und Galvanik war ebenfalls deutlich schlechter als in den Beispielen 1 und 2.

Vergleichsbeispiel 2

Unter Rühren wurde eine 48 %ige homogene Lösung in Aceton/Methanol 1:1 mit folgenden Bestandteilen hergestellt:
61,0 % eines Copolymers aus 57 Gew.-% Methylmethacrylat, 23 Gew.-% Methacrylsäure, 20 Gew.-% Ethylacrylat mit einem mittleren Molekulargewicht von etwa 85000
18,5 % Trimethylolpropantriacrylat

13,5 % Tetraethylenglykoldimethacrylat
2,7 % Dibutylphthalat
1,23 % Bis(dimethylaminophenyl)[ethyl(phenyl)-aminophenyl]methan
0,07 % Malachitgrün
1,0 %Tribrommethylphenylsulfon
0,5 % Isopropylthioxanthon
1,5 % Ethyl-(p-dimethylamino)benzoat

Nach analoger Verarbeitung des Photoresistes wie in Beispiel 1 beschrieben zeigte sich, daß der Kontrast nach Belichtung wie auch bereits im Vergleichsbeispiel 1 deutlich schlechter war als in den Beispielen 1 und 2. Man erhielt nur eine Zunahme der Extinktion bei Belichtung von 0,26 (600 nm) auf 0,41 (600 nm). Der Kontrast des belichteten Resistes nach Entwicklung sowie allen Folgeprozessen bei der Herstellung von Leiterplatten war wie im Vergleichsbeispiel 1 ebenflls deutlich schlechter als im Beispiel 1.

Beispiele 3 bis 4 sowie Vergleichsbeispiele 3 bis 8

Wie bereits aus den Beispielen 1 und 2 und den Vergleichsbeispielen 1 und 2 hervorgeht, erhält man eine besonders große Zunahme der Extinktion bei Belichtung durch eine Kombination aus 2,2'-Bis-(o-chlorphenyl)-4,4',5,5'-tetra-(p-methoxyphenyl)-bisimidazolyl und Tribrommethylphenylsulfon. In den Beispielen 3 bis 4 und den Vergleichsbeispielen 3 bis 8 wird gezeigt, daß die Kombination eines Imidazolyl-Dimeren mit einem halogenierten Sulfon zu einem besseren Print-Out-Image führt, als die Verwendung eines einzigen Photooxidationsmittels.

Hierzu wurde eine photopolymerisierbare Zusammensetzung, wie sie im Beispiel 2 erwähnt wird, verwendet.

Tabelle

| Bsp. Nr. | Vbsp. Nr. | Imidazolyl-Dimer | Tribrommethylphenylsulfon | Zunahme der Extinktion bei Belichtung | | |
|---|---|---|---|---|---|---|
| | | | | von | nach | (600 nm) |
| 3 | | 2,0 | 0,1 | 0,25 | 0,79 | |
| 4 | | 0,1 | 2,0 | 0,25 | 0,61 | |
| | 3 | 2,0 | 0,0 | 0,25 | 0,49 | |
| | 4 | 0,1 | 0,0 | 0,25 | 0,32 | |
| | 5 | 0,0 | 0,1 | 0,25 | 0,45 | |
| | 6 | 0,0 | 2,0 | 0,25 | 0,51 | |
| | 7 | 2,1 | 0,0 | 0,25 | 0,52 | |
| | 8 | 0,0 | 2,1 | 0,25 | 0,54 | |

Wie aus den Beispielen 1 bis 4 im Vergleich mit den Vergleichsbeispielen 1 bis 8 eindeutig hervorgeht, kommt es durch die Kombination von mindestens zwei Photooxidationsmitteln, insbesondere bei Verwendung von Kombinationen eines Imidazolyl-Dimeren mit einem halogenierten Sulfon, zu einem hervorragenden Kontrast.

Beispiel 5

Unter Rühren wurde eine 46,5 %ige homogene Lösung in Aceton/Methanol 1:1 mit folgenden Bestandteilen hergestellt:

63,0 % eines Copolymers aus 40 Gew.-% Methylmethacrylat, 25 Gew.-% Methacrylsäure, 25 Gew.-% Ethylacrylat und 10 Gew.-% Methylmethacrylat mit einem mittleren Molekulargewicht von etwa 105000
16,0 % Trimethylolpropantriacrylat
13,0 % Tetraethylenglykoldimethacrylat
2,7 % Dibutylphthalat

1,23 % Bis(dimethylaminophenyl)[ethyl(phenyl)-aminophenyl]methan
0,07 % Malachitgrün
1,0 % 2,2′-Bis(o-chlorphenyl)-4,4′,5,5′-tetra-(p-methoxyphenyl)-bisimidazolyl
1,0 % Tribrommethylphenylsulfon
0,5 % Isopropylthioxanthon
1,5 % Ethyl-(p-dimethylamino)benzoat

Nach Herstellung eines Trockenfilmresistes nach dem in Beispiel 1 beschriebenen Verfahren wurde der Resist auf ein kupferkaschiertes Basismaterial laminiert und anschließend bildmäßig mit einer Belichtungsvorlage belichtet. Der so hergestellte belichtete Resist zeigte einen sehr guten Kontrast nach Belichten zu unbelichteten Resistpartien.

Beispiel 6

63,0 % eines Copolymers aus 40 Gew.-% Styrol, 25 Gew.-% Methacrylsäure, 25 Gew.-% Ethylacrylat und 10 Gew.-% Methylmethacrylat mit einem mittleren Molekulargewicht von etwa 105000
13,0 % Trimethylolpropantriacrylat
12,0 % Tetraethylenglykoldimethacrylat
4,0 % Poly[N-vinylpyrrolidon] Mn ca. 33000
2,7 % Dibutylphthalat
1,23 % Bis(dimethylaminophenyl)[ethyl(phenyl)-aminophenyl]methan
0,07 % Malachitgrün
1,0 % 2,2′-Bis(o-chlorphenyl)-4,4′,5,5′-tetra-(p-methoxyphenyl)-bisimidazolyl
1,0 % Tribrommethylphenylsulfon
0,5 % Isopropylthioxanthon
1,5% Ethyl-(p-dimethylamino)benzoat

Wie bereits die vorangegangenen Beispiele zeigte auch dieser Photoresist ein hervorragendes Print-Out-Image.

Beispiel 7

Unter Rühren wurde eine 48 %ige homogene Lösung in Aceton/Methanol 1:1 mit folgenden Bestandteilen hergestellt:
61,0 % eines Copolymers aus 57 Gew.-% Methylmethacrylat, 23 Gew.-% Methacrylsäure, 20 Gew.-% Ethylacrylat mit einem mittleren Molekulargewicht von etwa 85000
18,0 % Trimethylolpropantriacrylat
13,0 % Tetraethylenglykoldimethacrylat
2,7 % Dibutylphthalat
1,25 % Kristallviolettleukobase
0,05 % Flexoblau (Triphenylmethanfarbstoff der BASF Aktiengesellschaft)
1,0 % 2,2′-Bis(o-chlorphenyl)-4,4′,5,5′-tetra-(p-methoxyphenyl)-bisimidazolyl
1,0 % Tribrommethylphenylsulfon
0,5 % Isopropylthioxanthon
1,5 % Ethyl-(p-dimethylamino)benzoat

Beispiel 8

Unter Rühren wurde eine 48 %ige homogene Lösung in Aceton/Methanol 1:1 mit folgenden Bestandteilen hergestellt:
61,0 % eines Copolymers aus 57 Gew.-% Methylmethacrylat, 23 Gew.-% Methacrylsäure, 20 Gew.-% Ethylacrylat mit einem mittleren Molekulargewicht von etwa 85000
18,0 % Trimethylolpropantriacrylat
13,0 % Tetraethylenglykoldimethacrylat
2,7 % Dibutylphthalat
1,25 % Kristallviolettleukobase
0,05 % Sicometpatentblau

1,0 % 2,2′-Bis(o-chlorphenyl)-4,4′,5,5′-tetra-(p-methoxyphenyl)-bisimidazolyl
1,0 % Tribrommethylphenylsulfon
0,05 % Isopropylthioxanthon
1,5 % Ethyl-(p-dimethylamino)benzoat

Beispiel 9

Unter Rühren wurde eine 48 %ige homogene Lösung in Aceton/Methanol 1:1 mit folgenden Bestandteilen hergestellt:
28,0 % eines Copolymers aus 60 Gew.-% Methylmethacrylat, 30 Gew.-% N-Vinylpyrrolidon und 10 Gew.-% Methacrylsäure mit einem mittleren Molekulargewicht von etwa 90000
33,0 % eines Oligomeren aus Bisphenol A-diglycidether (5 Teile), Adipinsäure (1 Teil) und Phthalsäureanhydrid (2,5 Teile)
18,0 % Trimethylolpropantriacrylat
13,0 % Tetraethylenglykoldimethacrylat
2,7 % Dibutylphthalat
0,05 % Sicometpatentblau
1,0 % 2,2′-Bis(o-chlorphenyl)-4,4′,5,5′-tetra-(p-methoxyphenyl)-bisimidazolyl
1,0 % Tribrommethylphenylsulfon
0,5 % Isopropylthioxanthon
1,5 % Ethyl-(p-dimethylamino)benzoat

Beispiel 10

Unter Rühren wurde eine 46 %ige homogene Lösung in Essigester mit folgenden Bestandteilen hergestellt:
61,0 % eines Polymers aus Methylmethacrylat mit einem mittleren Molekulargewicht von etwa 70000
19,0 % Trimethylolpropantriacrylat
12,0 % Butandioldiacrylat
2,0 % Dibutylphthalat
1,25 % Kristallviolettleukobase
0,05 % ®Sicometpatentblau 80 E 131 (BASF Farben + Fasern Aktiengesellschaft)
1,0 % 2,2′-Bis(o-chlorphenyl)-4,4′,5,5′-tetra-(p-methoxyphenyl)-bisimidazolyl
1,0 % Tribrommethylphenylsulfon
0,6 % Isopropylthioxanthon
1,5 % Ethyl-(p-dimethylamino)benzoat
0,8 % Benztriazol

Alle in den Beispielen 5 bis 10 hergestellten lichtempfindlichen Zusammensetzungen zeigten einen sehr guten Farbumschlag nach der Belichtung.

Beispiel 11

Es wurde wie im Beispiel 5 gearbeitet, diesmal wurde jedoch anstelle von Tribrommethylphenylsulfon nacheinander folgende Verbindungen eingesetzt:
Trichlormethylphenylsulfon
Dichlormethylphenylsulfon
Dibrom(nitril)methylphenylsulfon
Dibrom(phenyl)methylphenylsulfon
Dichlor(methylamino)methylphenylsulfon
Dibrom(methyl)phenylsulfon

Es resultierte stets ein guter Farbumschlag nach Belichtung.

Beispiel 12

Die im Beispiel 1 aufgeführte Lösung wurde als Überzug auf dünne Aluminiumplatten, wie sie üblicherweise für Offsetlithographien verwendet werden, aufgebracht. Nach dem Belichten im aktinischen Bereich besaßen die Druckplatten eine sehr gute Wiedergabe der Belichtungsvorlage sowie nach dem Entwickeln in einer wäßrig alkalischen Lösung einen sehr guten Kontrast zum Basismaterial.

| Beispiel 13 | |
|---|---|
| 33 %ige Lösung (in Wasser) von Mowiol® 04-M1 (Mowiol 04-M1 ist ein Polyethylenoxid-Polyvinylalkohol-Pfropfcopolymer der Fa. Hoechst AG) | 300,00 g |
| 28 %ige Lösung (in Methanol) von 2-Hydroxy-3-phenoxypropylacrylat | 280,00 g |
| Benzildimethylketal | 3,00 g |
| Bis(dimethylaminophenyl)[ethyl(phenyl)aminophenyl]methan | 0,10 g |
| 2,2'-Bis(o-chlorphenyl)-4,4',5,5'-tetraphenylbisimidazolyl | 0,50 g |
| Tribrommethylphenylsulfon | 1,0 g |

Die durch zweistündiges Rühren bei 60 °C homogenisierte Emulsion wurde auf ein haftungsvermittelnd vorbehandeltes Stahlblech aufgegossen und so abgerakelt, daß nach 1 Stunde Trocknen bei 60 bis 100 °C eine 0,4 mm dicke photopolymerisierbare Schicht entstand. Nach 2 Tagen Lagerung im Dunkeln wurden die erhaltenen photopolymerisierbaren Druckplatten 4 Minuten durch ein in engem Kontakt auf der lichtempfindlichen Schicht aufliegendes Filmnegativ belichtet. Als Belichtungsgerät wurde ein handelsüblicher Druckplattenbelichter mit 40 Watt-Leuchtstoffröhren mit Emissionsmaximum bei 350 nm als Lichtquelle verwendet. Bei der Belichtung färbten sich die exponierten Stellen intensiv blau, wodurch eine einfache optische Beurteilung des Belichtungserfolges ermöglicht wurde. Nach der Belichtung wurden die nicht exponierten Teile der Photopolymerschicht durch Ausprühen mit Leitungswasser entfernt und die Druckform 30 Minuten bei 80 °C getrocknet. Die Verwendung des farbgebenden Systems beeinflußte die drucktechnischen Eigenschaften des fertigen Klischees nicht.

## Ansprüche

1. Lichtempfindliche Zubereitung, im wesentlichen bestehend aus
(a) einem oder mehreren Farbbildnersystemen,
(b) gegebenenfalls einem oder mehreren filmbildenden polymeren Bindemitteln,
(c) gegebenenfalls einer oder mehreren Verbindungen mit mindestens einer ethylenisch ungesättigten Doppelbindung,
(d) gegebenenfalls einem durch Bestrahlung mit aktinischem Licht, aktivierbaren Photoinitiator oder Photoinitiatorsystem und
(e) gegebenenfalls Zusatz- und Hilfsstoffen,
dadurch gekennzeichnet, daß die lichtempfindliche Zubereitung als Farbbildnersystem (a) ein Gemisch aus
(I) mindestens einem Hexaarylbisimidazol der Formel (I)

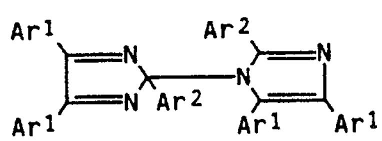

(I)

worin $Ar^1$ für einen substituierten oder unsubstituierten Phenylrest und $Ar^2$ für einen Phenylrest oder einen in 2- oder 2'-Position durch Halogen oder einen Alkylrest substituierten Phenylrest stehen,
oder einer strukturisomeren Form davon und
(II) mindestens einer halogenhaltigen Verbindung der allgemeinen Formel (II),

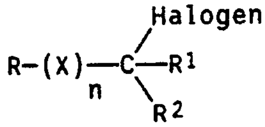

(II)

worin

R für einen unsubstituierten oder substituierten Alkyl-, Cycloalkyl-, Aryl-, Hetaryl- oder heterocyclischen Rest, oder den Rest

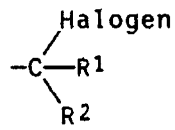

X für SO oder $SO_2$,

n = 1 oder 2,

$R^1$ und $R^2$ untereinander gleich oder verschieden sind und für ein Wasserstoffatom, Halogenatom, CN, unsubstituierte oder durch Halogen, CN, OH, $NO_2$, COOH, $CONR^3{}_2$ (mit $R^3$ = H, Alkyl, Cycloalkyl oder heterocyclischer Rest), $COOR^4$, (mit $R^4$ = Alkyl, Cycloalkyl oder heterocyclicher Rest) oder Alkoxy substituierte Alkyl-, Cycloalkyl-, Aryl- oder Hetarylgruppen stehen,

und

(III) mindestens einem zu einem Farbstoff oxidierbaren Farbbildner enthält.

2. Zubereitung nach Anspruch 1, dadurch gekennzeichnet, daß im Farbbildnersystem (a) die Komponenten (I) und (II) im Verhältnis 1:100 bis 100:1 vorhanden sind.

3. Zubereitung nach Anspruch 1 oder 2, dadurch gekennzeichnet, daß im Farbbildnersystem (a) als zu einem Farbstoff oxidierbarer Farbbildner (III) mindestens ein Leukofarbstoff enthalten ist.

4. Zubereitung nach einem der vorhergehenden Ansprüche, dadurch gekennzeichnet, daß im Farbbildnersystem (a) als halogenhaltige Verbindung (II) mindestens eine Verbindung der Formel

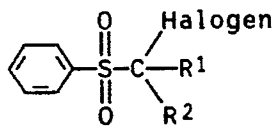

oder

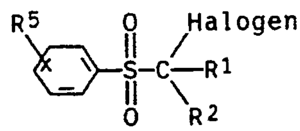

worin Halogen für Chlor oder Brom, $R^1$ und $R^2$ untereinander gleich oder verschieden sind und für Wasserstoff, Chlor oder Brom und $R^5$ für einen Alkylrest mit 1 bis 4 Kohlenstoffatomen stehen, enthalten ist.

5. Zubereitung nach einem der vorhergehenden Ansprüche, dadurch gekennzeichnet, daß als filmbildendes polymeres Bindemittel (b) ein Copolymerisat mit einer Säurezahl zwischen 50 und 200 enthalten ist.

6. Verfahren zur Herstellung von Photoresisten, dadurch gekennzeichnet, daß eine lichtempfindliche Zubereitung gemäß einem der vorhergehenden Ansprüche eingesetzt wird.

7. Verfahren zur Herstellung von Flachdruckplatten, dadurch gekennzeichnet, daß eine lichtempfindliche Zubereitung gemäß einem der Ansprüche 1 bis 5 eingesetzt wird.

8. Verfahren zur Herstellung von Hochdruck-, Flexodruck- oder Tiefdruckplatten, dadurch gekennzeichnet, daß eine lichtempfindliche Zubereitung gemäß einem der Ansprüche 1 bis 5 eingesetzt wird.

9. Verfahren zur Herstellung von photopolymerisierbaren und/oder thermisch verarbeitbaren Kopiermassen, dadurch gekennzeichnet, daß eine lichtempfindliche Zubereitung gemäß einem der Ansprüche 1 bis 5 eingesetzt wird.